# EUROPEAN PATENT APPLICATION

(11) **EP 2 075 834 A1**
(43) Date of publication of application: **01.07.2009**
(21) Application number: 08150793.1
(22) Date of filing: 29.01.2008
(51) Int. Cl.: H01L 23/485

(54) **Solder bumps for flip chip bonding with higher density**

(30) Priority: 28.12.2007 US 17282 P
(71) Applicant: INTERUNIVERSITAIR MICROELEKTRONICA CENTRUM vzw (IMEC), 3001 Leuven (BE); Katholieke Universiteit Leuven, K.U. Leuven R&D, 3000 Leuven (BE)
(72) Inventor: Limaye, Paresh, 3000 Leuven (BE); Labie, Riet, 3010 Kessel-lo (BE); Beyne, Eric, 3001 Leuven (BE); Soussan, Philippe, 3000 Leuven (BE); De Moor, Piet, 3210 Linden (Lubbeek) (BE)
(74) Representative: Hertoghe, Kris Angèle Louisa

(57) **Abstract**

An interconnect structure has a solder bump for attaching a die to a substrate. A cup shaped solder retaining part (70) retains at least part (90) of the solder in a non-spherical shape so that the bump extends from a surface of the die with a height greater than a diameter of the bump even after reflow. The bump can be formed by a stack of the solder retaining part and other layers of metal and solder (50). By shaping the solder, the spacing between bumps reduced. By shaping the solder to increase its height, the compliance of the bump is improved and thermally induced stress on the die is reduced.

## Description

### Technical field of the invention

The present invention relates to interconnect structures having solder bumps shaped for higher density of interconnects, to flip chip assemblies having such interconnect structures, to methods of manufacturing such interconnect structures, and to methods of manufacturing flip chip devices.

### Description of the Related Art

It is known to provide interconnections using solder bumps on the surface of a semiconductor chip, formed by for example an evaporation method, plating method, or printing method.

It is known from US2003214036 to provide under bump metallurgy structural designs to form solder bumps for attaching dies to flip-chip packaging. It is known to provide a metal layer in the form of an Under Bump Metallurgy (UBM) structure on a die pad, and a solder ball on top of the UBM structure. The solder ball is used to form an electrical and mechanical connection between the die and a substrate such as a Printed Circuit Board (PCB) or other device. It is also known from this document that an issue of concern in flip chip packaging is solder fatigue. In a typical device, a solder ball provides a joint between two substrates, such as a die and a PCB, that have differing coefficients of thermal expansion, typical values can be 3 ppm per degree for a silicon wafer, and 16 ppm per degree for laminate of a PCB. Consequently, varying amounts of stress and strain are applied to the joints as the device is exposed to thermal cycles. Any cracking may result in mechanical and/or electrical failure of the joint.

To reduce solder joint fatigue it is known to provide different solder ball compositions or a Stress Compensation Layer (SCL) around the solder joint before the solder ball is attached, to provide additional mechanical integrity. Another alternative is reinforcing the solder joints after attaching the die by an underfill operation. This involves flowing an adhesive between the die and a PCB after the die is attached. The laminar flow of adhesive between the two structures is facilitated by capillary action. Because the adhesive forms an additional load-bearing structure between the die and the package, stresses on the solder joint are alleviated somewhat.

The document suggests providing a die having a die pad disposed thereon, depositing a photo-definable polymer on the die pad, creating an aperture in the photo-definable polymer, and depositing a UBM layer onto the surfaces of the SCL. Such UBMs may be, for example, bowl-shaped or stud-shaped. A solder ball may be placed on top of the UBM so that, after reflow, the solder bump sits inside the UBM, to provide a large area of contact between the solder and the UBM, thus improving the solder-UBM bond. The UBM has a thickness of greater than about 20 microns, to improve package reliability and lifetime. The die package may also include an SCL.

Also known is Fujitsu's ™ Super CSP technology which is based on a solder ball on a Cu post or stud. This has redistribution to a peripheral pad array carried out using a sputtered and electroplated titanium (Ti)/Ni/Cu metallisation with a Pl dielectric. To prevent interdiffusion of the Cu to the solder, an Ni/palladium (Pd) layer is plated on top of the Cu stud. A polymeric resin is moulded between the studs and pre-formed solder balls are placed on top of the stud.

### Summary of the Invention

An object of the invention is to provide improved apparatus or methods.

According to a first aspect, the present invention provides an interconnect structure having a solder bump for attaching a die to a substrate, the solder bump having solder and a solder retaining part to retain at least part of the solder in a non-spherical shape so that the bump extends from a surface of the die with a height greater than a diameter of the bump.

According to another aspect, the invention provides:
An integrated circuit die having a solder bump for attaching the die to a substrate, the solder bump having a solder retaining part to retain at least part of the solder in a non-spherical shape so that the bump extends from a surface of the die with a height greater than a diameter of the bump.

In embodiments of the present invention, at least 20% by volume of the solder bump is solder. In particular embodiments of the present invention, between 40% by volume and 60% by volume of the solder bump is solder. In other embodiments of the present invention, the solder bump is formed predominantly of solder, e.g. between 50% and 70% by volume of the solder bump is solder.

In all embodiments and aspects of the present invention, by having the solder retaining part, the solder can be shaped; otherwise through surface tension it tends to form a spherical shape. The spherical shape would usually limit the spacing of neighbouring bumps to something greater than a diameter of the sphere. By shaping the solder, the height of the bump can be greater than its diameter, and the spacing can be reduced accordingly. By having the bump predominantly of solder, and shaping the solder to increase its height rather than using a copper stud to raise a solder ball, the compliance of the bump is improved and so less thermally induced stress is carried by the die. Furthermore, by providing a solder retaining part, flowing over or flowing away of solder when heating or melting it is avoided.

Embodiments of the invention can have any other features added; some such additional features are set out in dependent claims and described in more detail below.

Another aspect provides a method of manufacturing such an interconnect structure.

Another aspect provides a flip chip assembly having such an interconnect structure.

Another aspect provides a method of manufacturing such a flip chip assembly.

Any of the additional features can be combined together and combined with any of the aspects. Other advantages will be apparent to those skilled in the art, especially over other prior art. Numerous variations and modifications can be made without departing from the claims of the present invention. Therefore, it should be clearly understood that the form of the present invention is illustrative only and is not intended to limit the scope of the present invention.

### Brief Description of the Drawings

How the present invention may be put into effect will now be described by way of example with reference to the appended drawings, in which:
Figures 1 to 8 show cross section views at successive stages of manufacture of an integrated circuit die having a solder bump according to an embodiment,
Figure 9 shows a flip chip assembly assembled with the integrated circuit of figure 8, according to an embodiment,
Figure 10 shows a cross section view approximately to scale, of an integrated circuit die having a solder bump according to an embodiment, and
Figures 11 to 13 show further embodiments.

### Description of Illustrative Embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

The term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

### Additional features:

Some additional features are as follows:
The solder retaining part can be shaped so as to surround the retained part of the solder by at least three sides. This helps to keep the solder in shape even during reflow.

The bump can comprise a stack comprising the solder retaining part and a further solder part. By stacking parts, the height of the bump can be built up from parts which are individually less high, which can make them easier to manufacture, which can be easier for further manufacturing (for gap-height limiting processes like underfilling) or which are more reliable.

The solder retaining part can have an elongate shape such that the part of the solder retained has a height perpendicular to the surface greater than a largest diameter of the retained solder. Such diameter is determined by selecting the largest one of all diameters of the retained solder in planes parallel to the surface. The solder retaining part can have an elongate shape so that the height of the retained part of the solder comprising a solder volume V is larger than the diameter of a perfect (hypothetical) solder ball comprising the same volume V.

The solder retaining part can have a cup shape with a bottom nearest the surface of the die. This is relatively easy to form by a layering process, and provides good mechanical support on three sides for the solder within the cup.

The solder can be arranged to fill the cup and extend beyond the cup. This can ensure the solder makes a good contact and provides a compliant material at the interface to the substrate. This is often a region of higher stresses, more prone to cracking.

The further solder can be arranged between the solder retaining part and the die. This can ensure a good contact and provides a compliant material at the interface to the die. This is also a region of higher stresses, more prone to cracking.

The stack can have a metal layer between the further solder and the die. This may improve performance in electro-migration testing for predetermined metal layers. The metal layer can be the die metallisation.

The die can have more than one solder bump, with a pitch between neighbouring bumps being in a range of any of less than 30 micrometers.

The solder bump can have a diameter of less than 40 micrometers or less than 20 micrometers and a height greater than the diameter by any of 10, 20, 50 and 100 per cent.

The method of manufacturing the integrated circuit die can involve forming the solder bump by thin film processing steps. These include but are not limited to the steps of plasma vapour deposition/sputtering or plating of metal films, depositing photo imageable layers, e.g. polymer layers, that can be patterned with photolithographic processes and filling cavities in the pattern with metals e.g. by means of electro-galvanic processes, removal of these photo imageable, e.g. polymer, layers once the electro-galvanic processes are completed, and etching of excess metal deposits to obtain the final shape. It can involve forming the solder retaining part by forming a mask having an aperture at the location of the bump, and forming a layer on a bottom and against sides of the aperture to form the solder retaining part.

Another step can involve forming a further mask for the solder, having a further aperture over the solder retaining part, and forming the solder to fill the solder retaining part and fill the further aperture.

A preceding step can be forming the metal layer. Another such step can be forming the further solder layer on the metal layer.

The method of manufacturing the flip chip assembly can involve aligning and bonding contacts on the substrate to a top surface of respective ones of the solder bumps. A further step can involve flowing an underfill material in between the solder bumps after bonding. Having taller narrower solder bumps makes it easier to use a cheaper underfill material as there is more clearance, and so particle size in the material can be larger.

The solder bump can be arranged to provide an electrically conductive interconnect between the die and the substrate. The solder retaining part can be shaped such that when performing reflow, the solder bump substantially retains its height and diameter. The solder retaining part can be shaped to be higher than its diameter, or lower than its diameter, if part of a stack which is higher. The die may be created without a surrounding SCL stress compensation layer (SCL).

For more strength, the solder retaining part can be of a material which forms a good bond with the solder. For example diffusion between these materials can create an intermetallic layer. This can occur if for example the solder retaining part comprises copper or a copper alloy and the solder ball comprises a tin-lead alloy. The solder retaining part should be thick enough to provide enough material for such diffusion. The solder retaining part may comprise or consist of a stack of different sublayers.

### Issues relating to the embodiments

At least some embodiments of this invention are concerned with fine pitch flip chip applications. The standoff of the solder interconnection scales down with pitch. Thus, for example, at 20 micrometers pitch, the solder interconnection diameter would be only 10 micrometers and the resulting standoff in the range of 7-10 micrometers. This poses challenges for the under-filling process, requiring the use of finer filler particles, thus increasing the cost. This problem can be alleviated if the standoff can be increased. Some embodiments of this invention enable this standoff to be increased by at least 2X without sacrificing the fine pitch. The minimum standoff obtained is determined largely by the dimensions of the solder retaining part in the form of a cylindrical/prismatic tube. The presence of this tube effectively molds the solder joint to acquire a shape that enables the bump to be longer in the direction perpendicular to the surface of the die than its dimension parallel to the die.

Increased standoff bumps as described here may also be more compliant than those made predominantly of a copper stud, and may help in improving the fatigue life of the assembly. This contrasts with the copper pillar approach where the higher standoff is achieved with a stiff copper pillar. While providing higher standoff, this approach does not make the interconnection more compliant and transfers the stresses normally accommodated by the soldered interconnection to the silicon die. The embodiments of the invention described here can provide a more compliant solder interconnection and reduce the stress locally induced in the silicon.

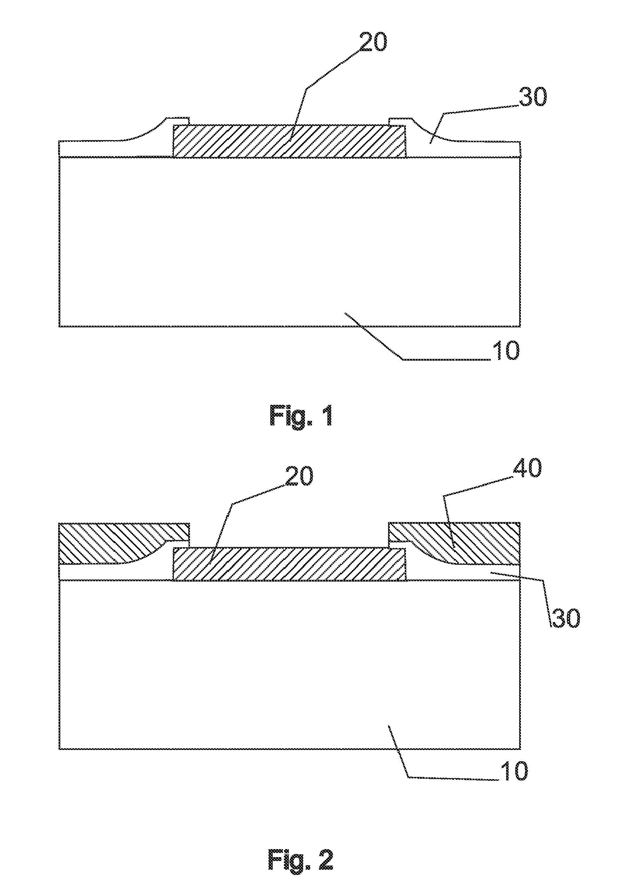

### Figures 1 to 8: Method of manufacture according to an embodiment:

A first embodiment of the invention involves creating a stacked flip chip bump in the following process steps:
As shown in figure 1, starting from a die 10 on which the bump is to be formed, a layer of photo-definable polymer is deposited over the die (not illustrated). The first polymer is then masked and exposed creating an opening which exposes a region for a pad for the bump. Next a first metal layer 20 is deposited in this opening (e.g. by means of electroplating or other process) and the first polymer is removed. This metal acts as an Under Bump Metallurgy (UBM). Optionally, this metal can be formed as a solder retaining part, and shaped in for example a cup shape. Optionally a seed layer may be laid over the UBM, following established practice. A passivating layer 30 may be formed over the die at locations not covered by the metal, in order to protect the die.

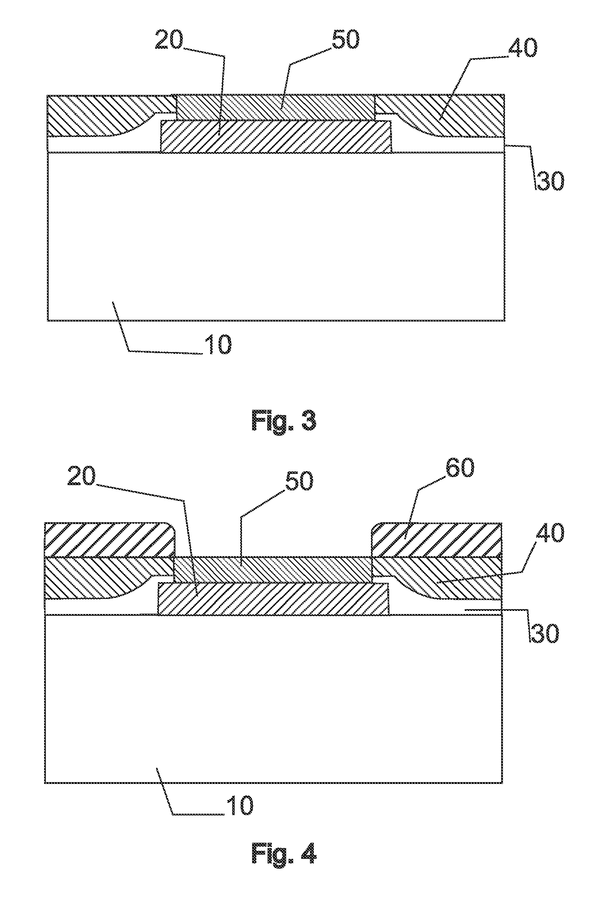

Then, as shown in figure 2, a second layer of polymer 40 is deposited on this layer. Next, this second polymer layer is masked and exposed creating an opening which exposes the first metal layer 20. In this opening, a part 50 of the solder of the bump material is deposited on top of the first metal layer, as shown in figure 3.

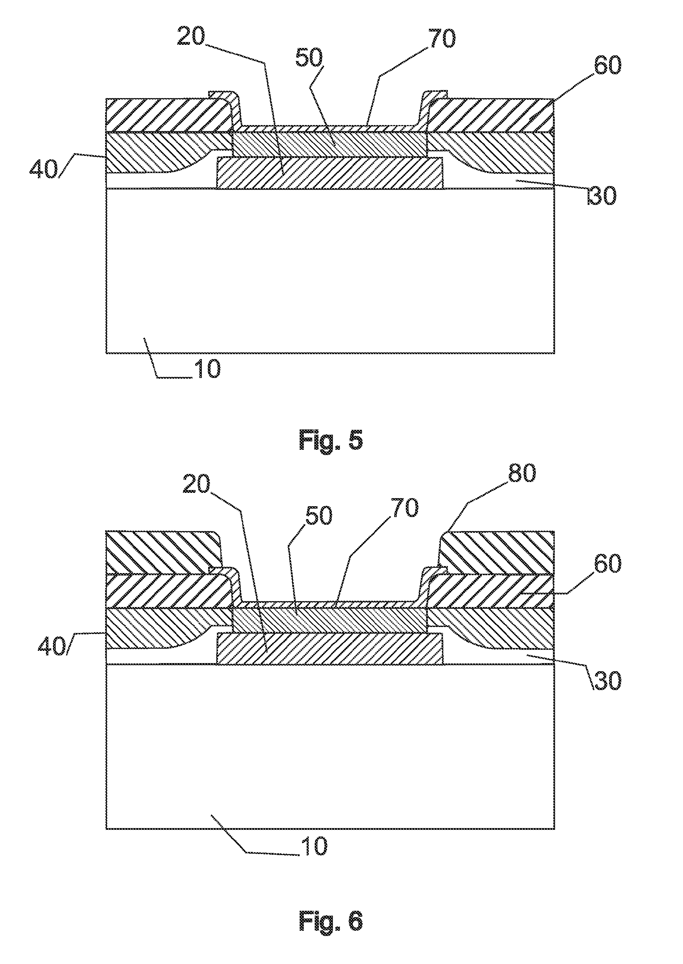

This is followed by deposition of a third polymer layer 60 as shown in figure 4. This polymer layer is then masked and exposed creating an opening exposing the solder. The shape of this opening can be chosen to be circular or elliptical or rectangular, or other shape, and will define the cross sectional plan view shape of the solder retaining part. A second metal layer 70 is then deposited on the first solder layer, and on the sides of the opening, to form the solder retaining part in a cup shape, as shown in figure 5.

This metal layer is then covered with the fourth polymer layer 80 as shown in figure 6.

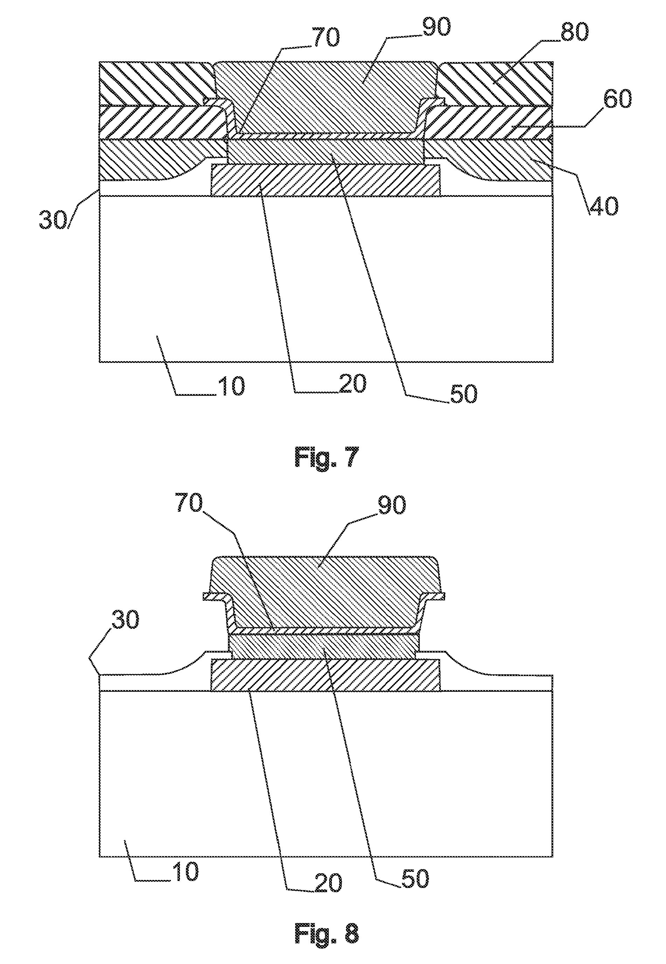

This fourth polymer layer is then masked and exposed to create an opening exposing the second metal layer. A seed layer may be deposited between polymer layers 60 and 70 or 70 and 80. A second part 90 of the solder is plated in this opening, to fill the solder retaining part and extend above the sides of the solder retaining part as shown in figure 7. The thickness of the second metal layer is such that the solder bump comprises more than 20%, more than 30%, more than 40 %, more than 50% or more than 70% or more than 80% solder by volume, for example, so that the solder bump is suitably compliant. Preferably the solder volume is comprised between 20% and 60 % by volume of the total bump volume.

After this step, all the polymer layers 40, 60, 80 used as masks are stripped away to leave the bump free-standing as shown in figure 8. All remaining seed layers which are not lifted-off during resist stripping can be etched away. Although only one bump is shown, there may be many bumps, closely spaced to increase interconnection density. The spacing may be smaller than a height of the bumps.

The photo-definable polymer may be, for example a conventional resist, or an epoxy which can be filled with borosilicate glass, quartz, silica, or glass beads. Optionally the polymer layer can be left in place to act as an SCL. In this case the coefficient of thermal expansion of the photo-definable polymer should be selected (for example, through suitable choice and amount of filler) so that it closely matches that of the die substrate, to improve its performance as a stress compensation layer. Moreover, since the polymer is photo-definable, it can be masked and exposed to create a hole or aperture of almost any desired shape or dimensions, which can be utilized in a subsequent metal deposition process to form a UBM layer having a desired configuration.

The first metal layer may be formed of for example any of copper, nickel, cobalt, silver or palladium or others, or alloys of these. The first solder part can comprise any of or any alloy of: tin, tin and silver, tin and lead, tin and silver and copper. The second solder part can comprise any of or any alloy of: tin, tin and silver, tin and lead, tin and silver and copper, and need not be the same as the first solder part. The second metal layer, forming the solder retaining part can comprise any of copper, nickel, cobalt, silver or palladium or others, or alloys of these.

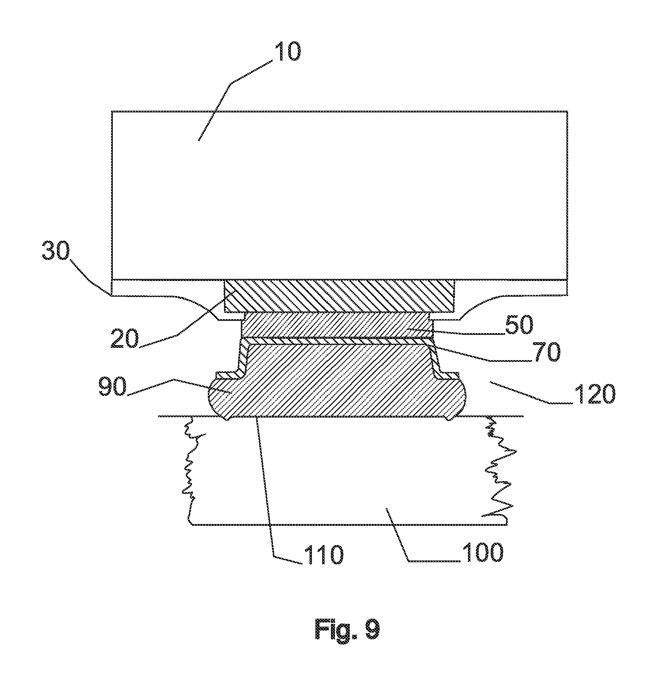

### Fig 9: flip chip assembly according to an embodiment

The die having the bumps is then bonded to a flip chip substrate 100, by turning over, aligning the bumps to bonding pads 110 on the substrate and bonding, as shown in figure 9. This bonding may be done using ultrasonic or other known techniques. The bumps are arranged so that the height after bonding known as the stand off, is similar to the height of the bumps, in other words, the bumps retain much of their shape and do not collapse. After bonding, an underfill material 120 may be flowed in between the substrate and the die to provide additional stress relief.

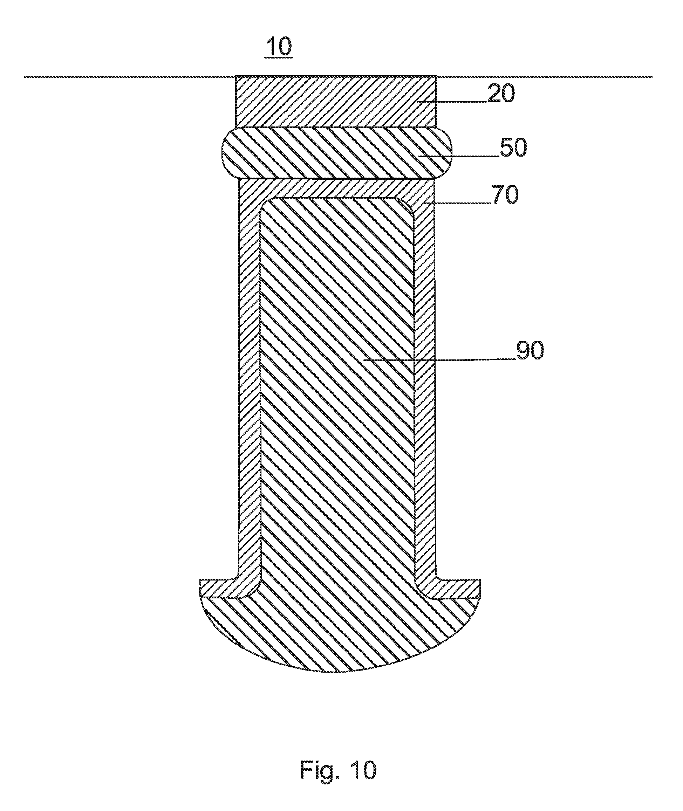

### Figure 10: scale view of solder bump

Figure 10 shows a side view in cross section of a solder bump with similar features to those of figure 8 and corresponding reference numerals have been used as appropriate.

It is shown approximately to scale. Other proportions and dimension can be used. This shows a stack 20,50,70,90 having a diameter of approximately 20 microns. The first metal layer is approximately 3-5 microns thick, and the first solder part is a layer approximately 5-10 microns thick. The second metal layer is approximately 1-5 microns thick, and in a cup shape having a height of approximately 25-50 microns, and diameter of 10-20 microns approx. It has a lip at its open end extending its diameter there to approximately 12 - 25 microns. The solder filling the cup extends higher than the cup by about 5-10 microns. Much of this excess height would be lost during bonding and so the total standoff would be approximately 25-50 microns in this case. A spacing between neighbouring bumps can be 10 to 25 microns. Clearly other dimensions can be used.

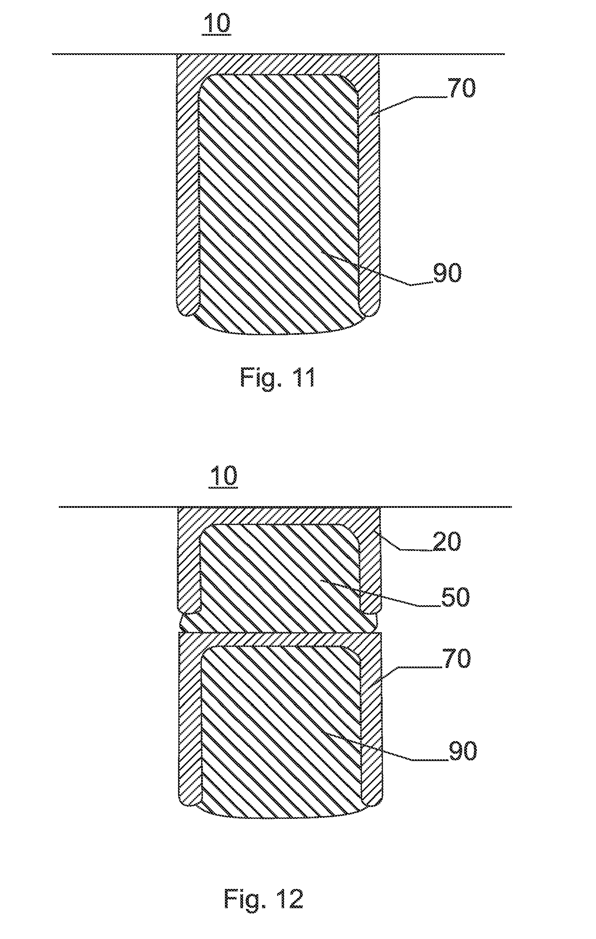

### Figures 11 to 13: Alternative embodiments

Figure 11 shows an alternative embodiment, in this case the cup is formed with one part of solder, and the solder retaining part is higher than its diameter. These features may be similar to corresponding features in figure 10 and corresponding reference numerals have been used as appropriate. In this case, fewer manufacturing steps are used.

Figure 12 shows another alternative embodiment. These features may be similar to corresponding features in figure 10 and corresponding reference numerals have been used as appropriate. In this case the first metal layer in the stack is formed as another solder retaining part. This means each of the solder retaining parts can be less elongate for a given height of the solder bump.

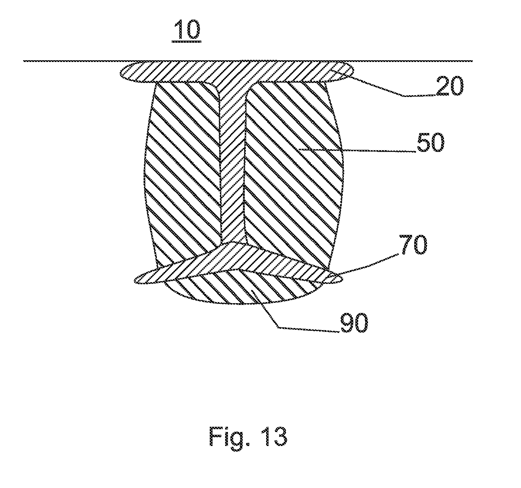

Figure 13 shows another alternative embodiment. In this case the first metal layer 20 is formed as a solder retaining part having a central spine rather than a cup shape. This is more difficult to produce than a cup shape and may need more than one masking and metal formation step. The first part of the solder is retained around the outsides of the spine and by a neighbouring surface of the second metal layer 70, so there is still effectively metal on three sides of the solder, to maintain the shape of the solder without it collapsing on reflow. A second part of the solder is retained on the top of the bump by the second metal layer 70 which is shown as a shallow cup shape. It is not essential that the first and second parts of the solder be kept separate.

Other variations can be envisaged within the scope of the claims.

## Claims

1. An interconnect structure having a solder bump for attaching a die (10) to a substrate (100), the solder bump having solder and a solder retaining part (70) to retain at least part (90) of the solder in a non-spherical shape so that the bump extends from a surface of the die with a height greater than a diameter of the bump

2. An interconnect structure according to claim 1, the solder retaining part being shaped so as to surround the retained part of the solder by at least three sides.

3. An interconnect structure according to claim 1 or 2, the solder bump comprising a stack comprising the solder retaining part and a further solder part (50).

4. An interconnect structure according to claim 3, the further solder part being arranged between the solder retaining part and the die.

5. An interconnect structure according to claim 4, the stack having a metal layer (20) between the further solder part and the die.

6. An interconnect structure according to any preceding claim, the solder retaining part having an elongate shape such that the part of the solder retained has a height perpendicular to the surface greater than a largest diameter of the retained solder.

7. An interconnect structure according to any preceding claim, the solder retaining part having a cup shape with a bottom nearest the surface of the die.

8. An interconnect structure according to claim 7, the solder being formed to fill the cup and extend beyond the cup.

9. An interconnect structure according to any preceding claim, the solder bump having a diameter of less than 20 micrometers and a height greater than the diameter by any of 10, 20, 50 and 100 per cent.

10. A method of manufacturing an interconnect structure having a solder bump for attaching a die to a substrate, the method having the steps of forming a solder retaining part (70), to have a shape to retain at least part (90) of solder of the solder bump in a non-spherical shape, and forming the solder in the retaining part so that the solder bump is so that the bump extends from a surface of the die with a height greater than a diameter of the bump.

11. The method of claim 10 involving forming the solder bump by thin film processing steps.

12. The method of claim 10 or 11, the step of forming the solder retaining part involving forming a mask (60) having an aperture at the location of the bump, and forming a layer on a bottom and against sides of the aperture to form the solder retaining part.

13. The method of claim 12 having the step of forming a further mask (80) for the solder, having a further aperture over the solder retaining part, and forming the solder to fill the solder retaining part and fill the further aperture.

14. The method of claim 13 having a preceding step of forming a metal layer (20) on the die, then forming a further solder layer (50) on the metal layer before forming the solder retaining part.

15. A flip chip assembly having the interconnect structure according to any of claims 1 to 9, and a substrate (100) bonded to a die by means of two or more of such interconnect structures.

16. The flip chip assembly of claim 15, a spacing between the bumps being less than a stand off height between the substrate and the die after bonding.

17. A method of manufacturing a flip chip assembly having a substrate (100) bonded to a die (10), having the steps of manufacturing an interconnect structure according to any of claims 10 to 14, and aligning and bonding contacts (110) on the substrate to a top surface of respective ones of the solder bumps of the interconnect structure.

18. The method of claim 17 having the step of flowing an underfill material (120) in between the solder bumps after bonding.
